Europäisches Patentamt

(19) European Patent Office

Office européen des brevets

(11) Publication number: **0 186 296**
**B1**

(12) **EUROPEAN PATENT SPECIFICATION**

(45) Date of publication of patent specification: **27.12.90**

(21) Application number: **85308284.0**

(22) Date of filing: **14.11.85**

(51) Int. Cl.⁵: **H 01 L 21/285, H 01 L 21/60**

(54) **Method of producing a contact on a semiconductor device.**

(30) Priority: **22.12.84 GB 8432572**

(43) Date of publication of application:
**02.07.86 Bulletin 86/27**

(45) Publication of the grant of the patent:
**27.12.90 Bulletin 90/52**

(84) Designated Contracting States:
**AT BE CH DE FR IT LI LU NL SE**

(56) References cited:
**EP-A-0 085 777**

**JAPANESE JOURNAL OF APPLIED PHYSICS SUPPLEMENTS, EXTENDED ABSTRACTS OF THE 16TH INTERNATIONAL CONFERENCE ON SOLID STATE DEVICES AND MATERIALS, 30th August - 1st September 1984, Kobe, JP, pages 47-50, Tokyo, JP; K. TSUKAMOTO et al.: "Self-aligned titanium silicidation by lamp annealing"**

(73) Proprietor: **STC PLC**
**10, Maltravers Street**
**London, WC2R 3HA (GB)**

(72) Inventor: **Scovell, Peter Denis**
**14 Staplecroft**
**Spring Field Chelmsford Essex (GB)**
Inventor: **Rosser, Paul John**
**120 Carters Mead Potter Street**
**Harlow Essex (GB)**

(74) Representative: **Dupuy, Susan Mary et al**
**STC Patents West Road**
**Harlow Essex CM20 2SH (GB)**

(56) References cited:
**EXTENDED ABSTRACTS, vol. 83, no. 1, May 1983, pages 569-560, abstract no. 371, Pennington, New Jersey, US; C.K. LAU: "Characterization of the self-aligned TiSi2 process"**

**IBM TECHNICAL DISCLOSURE BULLETIN, vol. 24, no. 4, September 1981, pages 1976-1977; C.Y. TING: "Using titanium nitride and silicon nitride for VLSI contacts"**

## Description

This invention relates to semiconductor processing and in particular to forming electrical contacts to silicon based semiconductor devices.

The conventional method of forming contacts to semiconductor devices involves opening a window in a dielectric layer disposed on a processed silicon substrate and then depositing a metal such as aluminium over the dielectric layer, and into the window, and subsequently defining tracks in the metal for device wiring. Contacts between the metal in the window and the underlying silicon are formed by annealing at 400—450°C, typically for fifteen minutes, to produce an ohmic contact. During this anneal, silicon from the substrate can migrate into the overlying metal at the contact and the aluminium migrates to fill the voids left in the substrate. This eventually causes severe junction leakage. Silicon is added to the aluminium to saturate the metal at the anneal temperature thus reducing the interdiffusion. Levels of 1 to 2% silicon in aluminium are commonly used for this purpose. This does, however, result in etching difficulities and hillock growth on the metal which can cause catastrophic failure in multi-layer metallisation schemes. To avoid junction leakage without saturating the aluminium with silicon would require a diffusion barrier between the substrate and the metal layer.

A known diffusion barrier layer is titanium nitride. A method of forming self-aligned titanium nitride contact between aluminium metallisation and an interconnect of metallic silicide, in particular titanium disilicide, is described in EP—A—0174773 (P. D. Scovell — P. J. Rosser — G. J. Tomkins) which belongs to the state of the art according to Article 54(3)EPC. This method involves disposing a dielectric layer, for example a thick silicon dioxide layer, over the entire wafer on which the titanium silicide interconnects are disposed, etching holes in the oxide to expose the silicide, annealing the wafer in nitrogen during which anneal nitrogen reacts with the exposed silicide to form titanium nitride regions thereat, depositing aluminium over the wafer and patterning it as required. Normally, titanium nitride contacts to silicon are formed by providing an oxide layer over a processed silicon wafer, etching windows in the oxide layer at regions were contacts are to be formed, sputtering titanium nitride over the oxide layer, defining contact areas photolithographically and etching the titanium nitride to leave pads over the windows. The nitride is, however, difficult to etch and any misalignment can cause a reliability hazard due to electromigration.

A method of forming self-aligned titanium disilicide contacts to monocrystalline or polycrystalline silicon regions is disclosed in EP—A—0 085 777. This method comprises the steps of:

providing an electrically insulating layer over a silicon substrate and exposing a region of the silicon via a hole in the insulating layer,

depositing titanium over the insulating layer and the exposed silicon region,

heating the structure so that the titanium in contact with silicon reacts to form titanium disilicide, and

removing unreacted titanium from the insulating layer.

According to the present invention there is provided a method for manufacturing a semiconductor device including the steps of providing an electrically insulating layer over a silicon layer or a silicon substrate and exposing a region of the silicon via a hole in the insulating layer, characterised by the subsequent steps of depositing titanium over the insulating layer and the exposed silicon region, causing titanium disilicide to be formed locally at the exposed region of silicon, removing unreacted titanium from the insulating layer, converting at least part of the titanium discilicide to titanium nitride and providing a metallisation layer over the insulating layer and the titanium nitride, the metallisation layer being in electrical contact with the silicon via the titanium nitride.

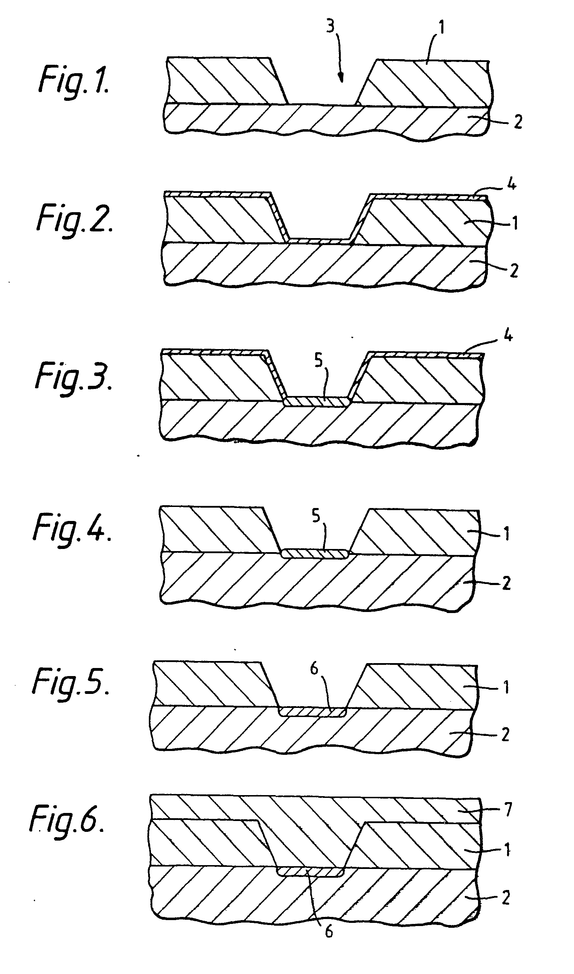

Embodiments of the present invention will now be described with reference to the accompanying drawings which illustrate in cross-section successive stages (Figs. 1 to 6) in the manufacture of an aluminium interconnect to silicon with a diffusion barrier interposed therebetween.

A method of automatically aligning a nitride pad to any silicon (polysilicon or single crystal) and according to the preent invention will now be described. A dielectric layer, for example a silicon dioxide layer 1, is provided on a silicon substrate or wafer 2 (or a silicide layer) and windows 3 etched in the oxide layer 1 to expose a contact region as in conventional processing (Fig. 1). A thin layer of titanium 4, approximately 100 nm (1000Å) is deposited over the entire wafer (Fig. 2). By performing a sinter anneal, such as 850°C for twenty seconds or 650°C for 30 minutes, on the wafer, titanium silicide 5 is formed at the contacts exposed by the windows 3 where the titanium is directly in contact with silicon (Fig. 3). Elsewhere titanium silicide is not formed. Any thin oxide layer inadvertently left in the contact will be reduced. The remaining unreacted titanium is washed off in a selective etch, such as ammonium hydroxide and hydrogen peroxide, together with any nitrides of titanium formed during sintering (Fig. 4). The wafer is then heated (annealed) in nitrogen to convert all or part of the titanium silicide 5 to titanium nitride 6 (Fig. 5), thus leaving a titanium nitride barrier self-aligned to the contact region. This annealing may be achieved by heating the wafer at 1100°C for a few seconds. Metallisation 7 (Fig. 6) is subsequently provided and etched in a conventional manner, the metallisation 7 being in electrical contact with the silicon 2 via the nitride 6. Aluminium metallisation can be of a pure aluminium or its alloy with silicon that has conventionally had to be employed. The titanium nitride barrier layer prevents junction spiking and obviates the need to add 1 to 2% silicon to aluminium interconnects.

## Claims

1. A method of manufacturing a semiconductor device including the steps of providing an electrically insulating layer (1) over a silicon layer or a silicon substrate (2) and exposing a region of the silicon via a hole (3) in the insulating layer, comprising the subsequent steps of

depositing titanium (4) over the insulating layer (1) and the exposed silicon region (2),

causing titanium disilicide (5) to be formed locally at the exposed region of silicon,

removing untreated titanium (4) from the insulating layer (1),

converting at least part of the titanium discilicide (5) to titanium nitride (6) and

providing a metallisation layer (7) over the insulating layer (1) and the titanium nitride (6), the metallisation layer (7) being in electrical contact with the silicon (2) via the titanium nitride (6).

2. A method as claimed in claim 1, characterised in that the silicon (2) is polycrystalline or single crystal in form.

3. A method as claimed in claim 1 or claim 2, characterised in that the insulating layer (1) is of silicon dioxide.

4. A method as claimed in any one of the preceding claims, characterised in that the titanium disilicide (5) is formed by a rapid anneal process comprising heating at 850°C for twenty seconds.

5. A method as claimed in any one of the preceding claims, characterised in that the unreacted titanium (4) is removed by a selective etch.

6. A method as claimed in any one of the preceding claims, characterised in that the titanium disilicide (5) is converted to titanium nitride (6) by annealing in nitrogen.

7. A method as claimed in any one of the preceding claims characterised in that the metallisation (7) is of pure aluminium.

## Patentansprüche

1. Verfahren zur Herstellung eines Halbleiterbauteils, wobei das Verfahren die Schritte der Schaffung einer elektrisch isolierenden Schicht (1) auf einer Siliziumschicht oder auf einem Siliziumsubstrat (2) und des Freilegens eines Bereiches des Siliziums über eine Öffnung (3) in der Isolierschicht einschließt und die darauffolgenden Schritte

der Abscheidung von Titan (4) über der Isolierschicht (1) undd dem freigelegten Siliziumbereich (2),

des Bewirkens der örtlichen Bildung von Titan-Disilizid (5) an dem freigelegten Bereich des Siliziums,

der Entfernung von kein Reaktion eingegangenem Titan (4) von der Isolierschicht (1),

der Umwandlung zumindestens eines Teils des Titan-Disilizids (5) in Titan-Nitrid (6), und der Ausbildung einer Metallisierungsschicht (7) über der Isolierschicht (1) und dem Titan-Nitrid (6) umfaßt, wobei die Metallisierungsschicht (7) über das Titan-Nitrid (6) in elektrischem Kontakt mit dem Silizium (2) steht.

2. Verfahren nach Anspruch 1, dadurch gekennzeichnet, daß das Silizium (2) eine polykristalline oder Einkristall-Form aufweist.

3. Verfahren nach Anspruch 1 oder 2, dadurch gekennzeichnet, daß die Isolierschicht (1) aus Siliziumdioxyd besteht.

4. Verfahren nach einem der vorhergehenden Ansprüche, dadurch gekennzeichnet, daß das Titan-Disilizid (5) durch einen schnellen Temperprozess gebildet wird, der das Aufheizen auf 850°C für 20 Sekunden umfaßt.

5. Verfahren nach einem der vorhergehenden Ansprüche, dadurch gekennzeichnet, daß das unreagierte Titan (4) durch ein selektives Ätzen entfernt wird.

6. Verfahren nach einem der vorhergehenden Ansprüche, dadurch gekennzeichnet, daß das Titan-Disilizid (5) durch Tempern in Stickstoff in Titan-Nitrid (6) umgewandelt wird.

7. Verfahren nach einem der vorhergehenden Ansprüche, dadurch gekennzeichnet, daß die Metallisierung (7) aus reinem Aluminium besteht.

## Revendications

1. Procédé pour fabriquer un composant semiconducteur, comprenant les étapes consistant à prévoir la présence d'une couche (1) életriquement isolante sur une couche de silicium ou un substrat (2) en silicium et à exposer une région du silicium par l'intermédiaire d'un trou (3) ménagé dans la couche isolante, le procédé comprenant les étapes subséquentes consistant à déposer du titane (4) sur la couche (1) isolante et sur la région (2) en silicium exposée, à provoquer la formation locale de disiliciure de titane (5) dans la région exposée du silicium, à enlever de la couche isolante (1) le titane (4) n'ayant pas réagi, à convertir au moins une partie du disiliciure de titane (5) en du nitrure de titane (6) et à fournir une couche (7) de métallisation par-dessus de la couche (1) isolante et le nitrure de titane (6), la couche (7) de métallisation étant en contact électrique avec le silicium (2) par l'intermédiaire du nitrure de titane (6).

2. Procédé tel que revendiqué à la revendication 1, caractérisé en ce que le silicium (2) est polycristallin ou sous forme de monocristal.

3. Procédé tel que revendiqué à la revendication 1 ou la revendication 2, caractérisé en ce que la couche isolante (1) est en bioxyde de silicium.

4. Procédé tel que revendiqué dans l'une quelconque des revendications précédentes, caractérisé en ce le disiliciure (5) de titane est formé par un procédé de recuit rapide comprenant un chauffage durant 20 s à 850°C.

5. Procédé tel que revendiqué dans l'une quelconque des revendications précédentes, caractérisé en ce que le titane (4) n'ayant pas réagi est enlevé par une attaque chimique sélective.

6. Procédé tel que revendiqué dans l'une quelconque des revendications précédentes, caractérisé en ce que le disiliciure (5) de titane est converti, par chauffage de recuit dans de l'azote, en du nitrure de titane (6).

7. Procédé tel que revendiqué dans l'une quelconque des revendications précédentes, caractérisé en ce que la métallisation (7) est en aluminium pur.

Fig.1.

Fig.2.

Fig.3.

Fig.4.

Fig.5.

Fig.6.